# EUROPEAN PATENT APPLICATION

(11) **EP 2 330 635 A1**
(43) Date of publication of application: **08.06.2011**
(21) Application number: 09177799.5
(22) Date of filing: 02.12.2009
(51) Int. Cl.: H01L 31/048, H01L 31/05

(54) **Interconnection Device**

(71) Applicant: Esmolo AG, 3007 Bern (CH)
(72) Inventor: De Luca, Riccardo, CH-3084, Wabern (CH)
(74) Representative: Rutz & Partner

(57) **Abstract**

The interconnection device (1) comprises a housing (10) accommodating connecting elements (141) designed for interconnecting ribbons (21) of a solar module (2), which are electrically connected to photovoltaic cells, with electrical conductors (12) that are coupled directly or via a control unit (11) to electrical connectors (13) that are accessible on the housing (10). According to the invention, each connecting element (141) is part of at least one rotatable fastening device (14; 14A, 14B, 14C), such as a mandrel. Further at least one catch (145, 1450) is provided designed for holding a related ribbon (21) in a holding section (142) and wherein the at least one rotatable fastening device (14) is rotatably held by at least one bearing (16), is coupled to at least one ratchet (18, 181), which allows turning the fastening device (14) in one direction only, and is accessible from the outside of the housing (10) .

## Description

The invention relates to an interconnection device for a solar module, particularly to an interconnection device for preventing unauthorized use of the solar module, and to a solar module provided with an interconnection device.

### BACKGROUND OF THE INVENTION

Solar modules serve for receiving and converting solar energy into electrical energy that can be provided to a local or public power grid. An energy supply system for collecting solar energy and providing electrical energy may comprise only one or a plurality of solar modules. The construction of solar modules is described for example in US5951786A. Typically a solar module consists of different layers comprising a layer made of glass on the front side, an EVA (ethylene vinyl acetate) layer, one or more strings of photovoltaic cells, another EVA layer and a backsheet layer preferably made of Tedlar® on the back side having good weather resistance, ultraviolet resistance and moisture barrier properties. To the backsheet layer an interconnection device is attached that may comprise a local control module or a switching device only. Typically the interconnection device is arranged within a housing that will be attached to the back of the solar module by means of silicon, glue or other means.

From WO 2009/093780 Al and US4367581A it is known that the photovoltaic cells of a solar module are electrically interconnected by means of ribbons. Therefore, also the output lines of the circuitry of the photovoltaic cells preferably consist of ribbons that are connected to the interconnection device by means of soldering or clamping. Soldering the ribbons to electrical contacts normally provides a good contact quality, if it is carefully performed. However, besides the regular occurrence of unsatisfactory contacts, soldering techniques are time-consuming and also have several disadvantages. It must be taken care that due to the impact of heat no parts of the solar module are damaged. Further, residual solder must be removed in order to avoid malfunctions.

Clamping the ribbons to electrical contacts can quickly be performed. However, the quality of the contact may gradually decrease during the lifetime of the solar module. Springloaded clamps may lose their force so that loose contacts may occur. Still further, the resulting contacts comprise typically a very small contact area so that oxidation of the contact material may lead to a significantly increased contact resistance.

Further, as described in W02009118068A1 the implementation of energy supply systems, particularly large scale energy supply systems that comprise numerous solar modules, requires a considerable investment and therefore protection against tampering and theft. Hence, each solar module is preferably provided with a local control unit comprising a switching module, which is controllable in such a way that the transfer of electrical energy from the photovoltaic cell via first and second wires of a power line to a load is interruptable in the event that a verification procedure fails. Unauthorised users of the solar modules may however obtain information of how to circumvent these safety measures and may reactivate a solar module that has been deactivated by the local control unit. Unauthorised users may for example replace electric or electronic modules, such as switches, which were interrupted or short circuited by the control unit.

The present invention is therefore based on the object of providing an interconnection device for a solar module that avoids the above described disadvantages of known systems and to a solar module provided with such an interconnection device.

In particular it is an object of invention to provide an interconnection device that allows establishing an electrical connection of high-quality between ribbons of the solar module and electrical contacts provided on the interconnection device.

It is another object of the invention to provide an interconnection device that can quickly and with little effort be installed, avoiding disadvantages of soldering and clamping methods.

It is a further object of the invention to provide an interconnection device that safely accommodates control circuitry and that can securely be fastened to the solar module, thus providing a high tampering resistance.

It is still another object of the invention to provide an interconnection device that discourages unauthorised persons from tampering with the solar module, particularly to access and manipulate the control circuitry that prevents unauthorised exploitation of the solar panel.

### SUMMARY OF THE INVENTION

The above and other objects of the present invention are achieved by an interconnection device and a solar module provided with such an interconnection device as defined in claim 1 and claim 14 respectively.

The interconnection device comprises a housing accommodating connecting elements, which are designed for interconnecting ribbons of a solar module that are electrically connected to photovoltaic cells, with electrical conductors that are coupled directly or via a control unit to electrical connectors that are accessible on the housing.

According to the invention, each connecting element is part of at least one rotatable fastening device, such as a mandrel. Further at least one catch is provided designed for holding a related ribbon in a holding section and wherein the at least one rotatable fastening device
a) is rotatably held by at least one bearing,
b) is coupled to at least one ratchet, which allows turning the fastening device in one direction only, and
c) is accessible from the outside of the housing.

Hence, the at least one fastening device, that is rotatable in one direction only, serves for coupling the ribbons of the solar module with electrical conductors provided with an interconnection device.

In a first principle embodiment the fastening devices are designed as screws that are held in a bearing that comprises a thread and that are rotatable with the connecting element formed by the tip of the fastening device towards the related catch that comprises the holding section. This holding section is a region of the catch that is preferably formed therein as a recess. Each electrical conductor may be arranged on the surface of the catch so that the related ribbon pressed against the catch by means of the fastening device thereby is contacting the electrical conductor. In the event that a recess is provided in the catch the ribbon is pressed into the recess and detained. In this first principle embodiment there is always a plurality of fastening devices provided.

The second principle embodiment may comprise a plurality of fastening devices or a common fastening device, e.g. a mandrel. According to the second principle embodiment the ribbons and preferably also the electrical conductors are wrapped around the at least one fastening device.

According to the second principle embodiment, each connecting element, which comprises at least one catch designed for grasping and holding a related ribbon within a holding section of the connecting element, is mounted on a fastening device

The inventive interconnection device therefore avoids soldering or punctually clamping the ribbons to electrical contacts and the related disadvantages. The ribbons and the electrical conductors are in laminar layers either pressed against each other by means of individual fastening devices or wrapped around the at least one fastening device.

In the second principle embodiment, by turning the fastening device, the ribbons are wound around the connecting element forming laminar layers on the connecting elements. Preferably, both, the ribbons and the electrical conductors provided in the interconnection device are layered up on each other. Preferably, the contact is established directly between the ribbons of the solar module and the electrical conductors of the interconnection device. Alternatively, an electrical contact is established between the ribbons of the solar module and the related connecting elements, which themselves are galvanically connected to the electrical conductors of the interconnection device. With this technique, the contact regions of the ribbons of the solar module and the contact areas of the electrical conductors or the connecting elements are laminarly adjoining each other. Due to the large contact areas an optimal contact with negligible contact resistance is obtained over the lifetime of the installed solar modules 2.

As soon as the ribbons are coupled to the connecting element the electrical contact can quickly be established by turning the fastening device.

Since the fastening device(s) of the first and second principle embodiment is/are coupled to a related ratchet, the fastening device can be turned in one direction only. Therefore, after the contact has been established, the fastening device will remain in position, holding the ribbons tight.

The ratchet is preferably designed and arranged in such a way that it cannot be released by unauthorised persons. In the event that the ratchet is not releasable at all, then the removal of the interconnection device leads to the destruction of the solar module, since the ribbons will be torn away. In order to ensure that no access to the elements of the interconnection device is provided to unauthorised persons the housing is designed tamper-proof.

In a preferred embodiment, the ratchet is designed releasable, providing access to the interconnection device for the authorised user. The ratchet may comprise an element that can lock the fastening device and that can be released from the fastening device. This locking element may for example slideably or pivotally be held and be released by a release mechanism. The release mechanism may apply a magnetic force to the locking element from the outside or inside of the interconnection device. This magnetic force may be derived from a permanent magnet or an electromagnet. The ratchet may be a simple locking element specifically designed for the interconnection device. Alternatively the ratchet may be purchased on the market. For example, the ratchet may comprise a lever that interacts with recesses or a toothed wheel provided on the fastening device. By turning the fastening device into one direction the lever is lifted along a first flank that is inclined relative to the radius of the toothed wheel. In the other direction the lever is blocked by a second flank that is radially aligned. Thus, a ratchet can easily be realised. In a preferred embodiment, the ratchet is incorporated into at least one of the bearings which hold the fastening device.

The coupling of the ribbons to the connecting elements of the fastening device according to the second principle may be performed in several ways.

In one embodiment, each catch is fixedly connected to the connecting element or to the fastening device or each catch is part of the connecting element or part of the fastening device. Therefore each catch is acting as a fork for picking up and holding a ribbon. For this purpose the connecting elements or the whole fastening device is shiftable along its longitudinal axis, so that each catch can grasp a ribbon. In preferred embodiments each connecting element comprises two, three or more catches.

In another embodiment each catch is pivotally mounted on the fastening device or on the connecting element. By rotating the catch the related ribbon is grasped and held attached to the fastening device or attached to the connecting element in a holding space, if any, provided therefore.

The catches provided may be actuated by a common closing bar that, for example, is held movable co-axially to the fastening device. The closing bar may be attached to or integrated into the fastening device, so that it does not constitute an obstacle during the process of winding the ribbon around the fastening device.

The fastening device extends out of an opening of the housing or is accessible through the opening and can be turned manually or with a tool, such as a screw driver.

In the most preferred embodiment the electrical conductors provided in the interconnection device are connected to a control unit, which is accommodated within the housing of the interconnection device. The control unit is programmed in such a way that it interrupts the transfer of electrical energy from the photovoltaic cell if the verification procedure, such as password verification, has failed. Preferably the solar module is designed in such a way that the password is erased or reset to a value known to the manufacturer only in the event that tampering or removable of the solar module has been detected for example by means of an acceleration sensor. Hence, after theft of the solar module the password stored in a control unit and known password will no longer match the password stored in control unit and therefore will be invalid.

The system disclosed in WO2009118068A1 comprises for each solar module a chip-card with a first access code that corresponds to a second access code that is stored in a memory unit of the control unit. The solar module comprises a card-reader, with which the first access code is transferable from the chip card to the memory unit of the local control unit, which performs the verification procedure. In the event that the access codes match, then the solar module is configured to be operative, else the functions of the solar module are at least partially disabled.

### BRIEF DESCRIPTION OF THE DRAWINGS

Some of the objects and advantages of the present invention have been stated, others will appear when the following description is considered together with the accompanying drawings, in which:
- Fig. 1: shows a solar module 2 comprising contacting ribbons 21, which are routed into an inventive interconnection device 1, which comprises a fastening device 14 with connecting elements 141 that, after installation, is mechanically and electrically coupled to the ribbons 1 and held by the ratchet 18, 181;
- Fig. 1a: shows the ratchet of fig. 1 that is interacting with a part of the fastening device 14 that is provided with the form of toothed wheel 1401.
- Fig. 2: shows the interconnection device 1 of fig. 1 during the process of mechanically coupling the ribbons 1 to the fastening device 14;
- Fig. 3: shows the interconnection device 1 of fig. 1 after the ribbons 21 have been coupled to the fastening device 14 and thus to the control unit 11 arranged within the interconnection device 1;
- Fig. 4a-4c: shows a further inventive embodiment of the fastening device 14;
- Fig. 5: shows an inventive interconnection device 1, which comprises a fastening device 14 as shown in fig. 4;
- Fig. 6: shows an inventive interconnection device 1 in a further principal embodiment; and
- Fig. 6a: shows a schematic view of one of the fastening devices 14 held by a bearing 60.

### DETAILED DESCRIPTION OF THE PREFERRED EMBODIMENTS

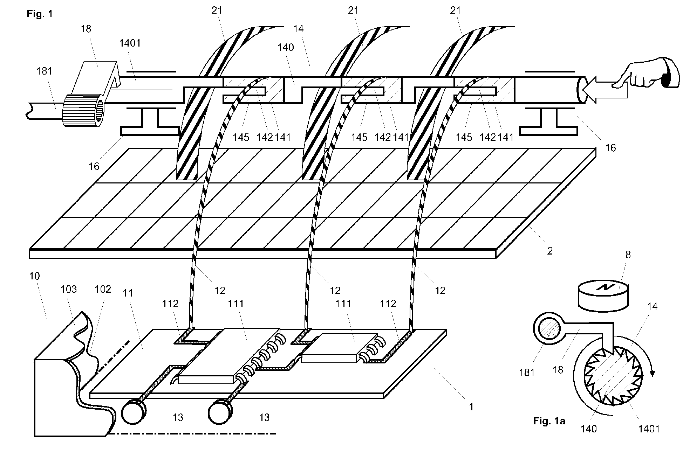

Figure 1 shows an inventive interconnection device 1 with a tamper-proof housing 10 that is installed on the backside of a solar module 2.

The interconnection device 1 serves for connecting the power output lines of the solar module 2 to electrical contacts 13 provided on the interconnection device 1. As described above the power output lines of the solar module 2 are typically realised in the form of flat ribbons 21 that are also used for interconnecting the photovoltaic cells that are arranged within the solar module 2.

The housing 10 comprises side walls 102 and a top 103 that inhibit access to the interior of the interconnection device 1 after it has been mounted on the solar module 2. A bottom of the housing 10 may optionally be provided or may be formed by the back side of the solar module 2, onto which the housing 10 is mounted. Since the interconnection device 1 is firmly mounted to the solar module 2 and can not be dismounted by unauthorised persons after installation, the housing 10 does preferably not comprise a bottom. If the bottom of the housing is missing, then free access to the interior of the interconnection device 1 is provided during the assembly process and later on during the installation of the interconnection device 1 on the solar module 2. In this embodiment, the mechanical and electrical parts of the interconnection device 1 may be mounted on the top cover 103. The ribbons 21 may freely enter the housing 10 from the bottom side if the bottom is missing or through openings 1011 in the bottom 101, if present.

During the installation process the ribbons 21 are mechanically connected to a fastening device 14 provided within the interconnection device 1. The fastening device 14 is rotatably held on bearings 16 that are firmly held by the housing 10. The bearings 16 may be mounted on the top cover 103, on the bottom 101, if present, or on the side walls 102. Preferably, the bearings 16 are integrated into the side walls 102.

The primary function of the fastening device 14 is to mechanically couple the ribbons 21 and to allow winding the ribbons 21 around the fastening device 14 until they are tightened, thus preventing the interconnection device 1 from being removed from the solar panel 2. For that purpose, the fastening device 14 is coupled to a ratchet or ratchet elements such as a ratchet lever 18 mounted on a shaft 181. The ratchet 18 allows the fastening device 14 to turn in one direction and prevents it from turning into the other direction. In a preferred embodiment the ratchet 18 is incorporated into at least one of the bearings 16 that hold the fastening device 14.

Figure 1a shows that a part of the body 140 of the fastening device 14 is formed as a toothed wheel 1401 with teeth that have a first flank radially aligned and a second flank inclined thereto. A lever 18, which is pivotally mounted on a shaft 181, is engaged in the toothed wheel and is lifted by a second flank if the fastening device 14 is turned clockwise. However, if the fastening device 14 is turned counter-clockwise then the first flank will be radially aligned with the front of the lever 18, which will prevent the fastening device 14 from turning. The ribbons 21 of the solar module 2 can therefore be wound clockwise around the fastening device 14 until they are tight. Afterwards the fastening device 14 will maintain the tension since it cannot turn back.

In a preferred embodiment a release mechanism is provided that allows the release of the ratchet 18. Figure 1a shows that the lever 18 can be lifted by means of a force that is applied for example by means of an electrical engine or by means of a magnet 8, such as a permanent magnet or an electromagnet. As soon as the permanent magnet 8 is arranged or the electromagnet 8 is activated above the ratchet lever 18 and the fastening device 14 is slightly turned clockwise, the ratchet lever 18 is released from the toothed wheel 1401 of the fastening device 14, which then can be turned counter-clockwise, disengaging the ribbons 21 from interconnection device 1.

For the purpose of coupling the ribbons 21 with the fastening device 14 contact elements 141 are provided that comprise a catch 145 which is designed for grasping and holding a related ribbon 21 within a holding section 142 of the connecting element 141. The contact elements 141 shown in figure 1 comprise the form of a fork that is aligned parallel to the axis of the fastening device 14 and that can engage with a ribbon 21 that has been introduced into the interconnection device 1. In order to facilitate the coupling of the ribbons 21 the connecting elements 141 may comprise two, three or more catches 145 that are evenly distributed around the fastening device 14.

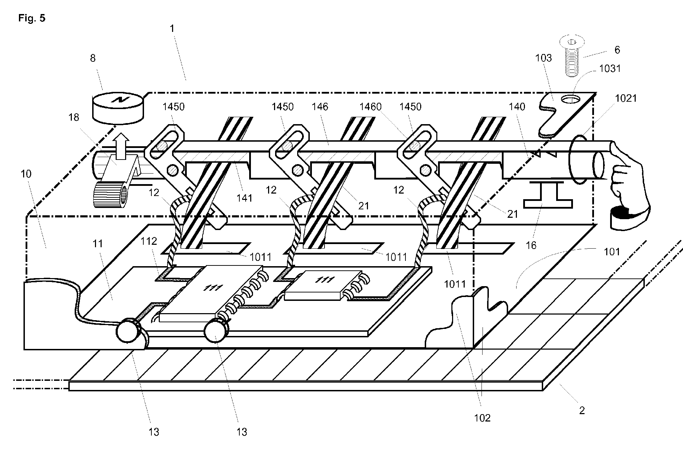

Coupling the ribbon 21 and introducing it into a holding section 142 of the connection element 141 can either be done manually or by axially moving the fastening device 14 towards the ribbons 21. In the event that the housing 10 of the interconnection device 1 does not comprise a bottom, then the ribbons 21 can manually be introduced into the holding sections 142 of the fork-like connecting elements 141. In this case may not need to be shifted horizontally. In the event that the housing 10 comprises a bottom 101 (see figure 5) then the ribbons 21 are introduced into the housing 10 through at least one opening 1011 provided in the bottom 101 and guided to a region above or below the fastening device 14, where they can engage with the catches 145. In the described embodiments the catches 145 preferably extend out of the openings 1011 or can be moved out of the openings 1011 so that the ribbons 21 can be caught outside of the housing 10 and will automatically be drawn into the housing 10, when the fastening device(s) 14 is/are shifted or activated.

In this preferred embodiment, the bearings 16 typically allow the fastening device 14 to be rotated and to be axially shifted towards the ribbons 21 in order to pick up the ribbons 21. However, if the fastening device 14 is arranged close to the opening 1011 provided in the bottom 101, then it may still be possible to manually engage the ribbons 21 in the catches 142 without shifting the at least one fastening device 14.

In order to manipulate the fastening device 14 in the above described manner, access to the fastening device 14 is required. Therefore, the fastening device 14 is either extending through an opening 1021 out of the housing 10 (see fig. 5), or is accessible by means of a tool, such as a screw driver or a wrench, that can be inserted into the opening 1021. The corresponding end of the fastening device 14 is adapted according to the applied tool and, for example, comprises the form of a bolt or a screw head.

Figure 1 further shows that the connecting elements 141 are coupled to electrical conductors 12 that lead to a control unit 11, which is connected to output connectors 13. The control unit 11 is implemented on a firm or flexible printed circuit board that comprises semiconductors 111 and printed electrical conductors 112. The control unit 11 preferably comprises a single chip computer, a communication unit and switching elements that can interrupt the power lines of the solar module 2. Preferably a wireless communication unit is provided that can communicate with a handheld terminal for exchanging data such as a password. In the event that the password corresponds to a stored password then the solar module 2 is activated, else it is disabled.

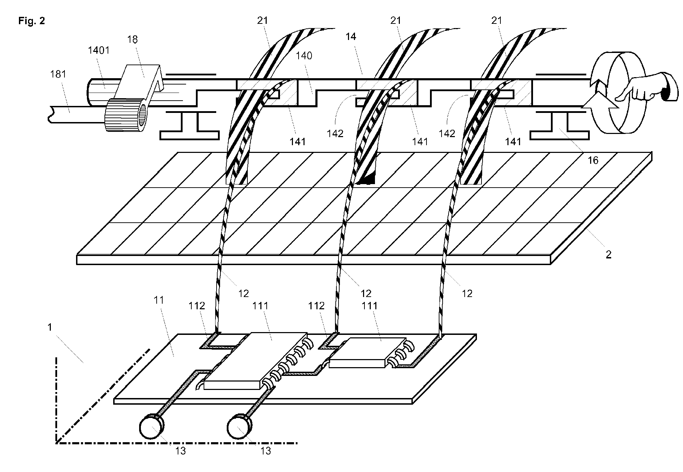

In figure 2, the ribbons 21 of the solar module 2 are engaged in the catches 142 of the connecting elements 141 so that the fastening device 14 can be turned in order to establish contact between the ribbons 21 and the electrical conductors 12, either directly or via the connecting element 141 that may be made of metal.

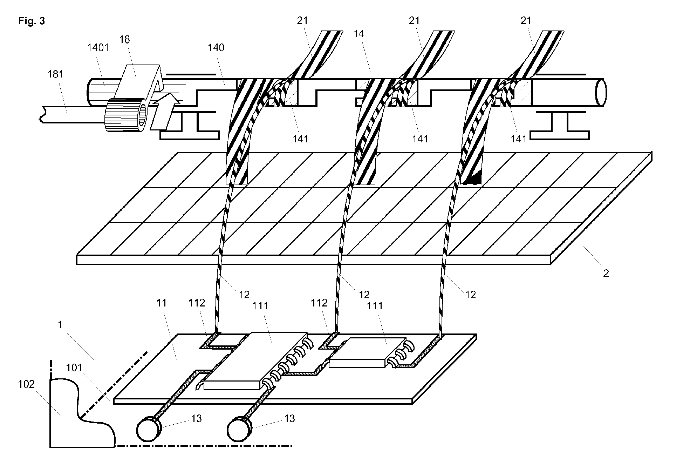

Figure 3 shows the ribbons 21 and the electrical conductors 12 wound a few turns around the fastening device 14. The ribbons 21 and the electrical conductors 12 are laminarly layered upon the connecting elements 141, exhibiting large contact areas that provide a negligible contact resistance. It is further shown that the ratchet lever 18 holds the fastening device 14 in position, so that it cannot turn back and release the pressure on the ribbons 21. In this state the fastening device 14 and thus the interconnection device 1 is mechanically and electrically coupled to the solar module 2. Removal of the interconnection device 1 under the impact of force will automatically rip apart the ribbons 21 and destroy the solar module 1. Hence, once the interconnection device 1 is installed, it cannot be removed by unauthorised persons. The interconnection device 1 can only be removed, if the ratchet lever 18 can be released with a suitable tool, such as an electromagnet 8. The electromagnet 8 is preferably arranged within the interconnection device 1 and being powered by the solar module 1 or an accumulator fed by the solar module 1. In the event that the electromagnet 8 is part of the control module 10, then preferably the release code is provided, that can be entered into the control module 10 in order to activate the electromagnet 8 and to release the fastening device 14. The owner may therefore use the permanent magnet or a release code as a key to release the installed interconnection device 1 from the solar module 2, e.g. by activating an electromagnet 8 or an electrical engine.

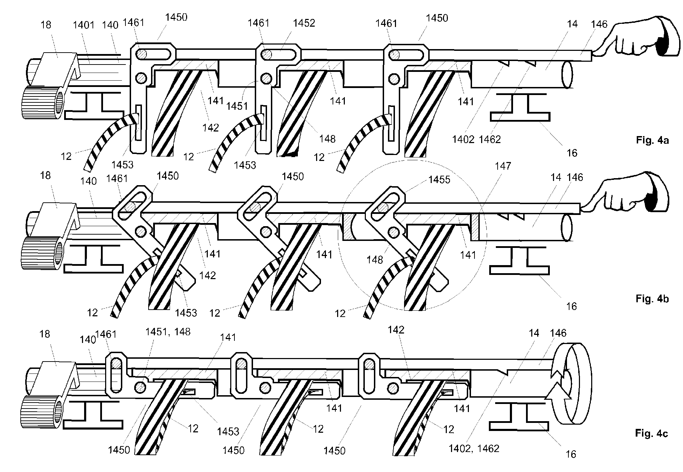

Figures 4a, 4b and 4c show a preferred embodiment of a fastening device 14 that comprises connecting elements 141 and catches 1450 that are pivotally mounted on an axle 148. The catches 1450, which are formed as levers, comprise a first opening 1451 for receiving said axle 148 and a second opening 1452 for receiving a coupling element 1461, such as a cam, that is mounted on a closing bar 146, which can be moved in parallel to the fastening device 40. Further provided is a third opening 1453, which is connected to the related electrical conductor 12. Connecting the electrical conductors 12 to the catches 142 has the advantage that the electrical conductors 12 are kept away from connecting elements 141 allowing the ribbons 21 to be mounted without interference.

As soon as the closing bar 146 is moved in parallel to the fastening device 14 towards the catches 1450, the catches 1450 are rotated towards the ribbons 21 that are sitting in the holding sections 142 or in recesses provided in the connecting elements 141. After the catches 1450 have been rotated by 90° the ribbons 21 are caught in the holding sections 142 and can not escape, when the fastening device 14 is turned. It is shown that the second opening 1452 of the catches 1450 is formed as a slit along which the coupling element 1461 can move, thus allowing the closing bar 146 to be moved linearly from one end to the other. Since little force is required for turning the catches 1450, the closing bar 146 can be dimensioned and installed accordingly. The closing bar 146 can be attached or fully or partially be integrated into the fastening device 14 that for this purpose would be provided, e.g. with a groove.

In the shown embodiment the closing bar 146 is provided with a hook 1462 that engages in a corresponding recess 1402 provided in the fastening device 14 as soon as the catches 1450 have been rotated into their final position. After the hook 1462 has engaged in the recess 1402 the catches 1450 remain closed. With the ribbons 21 captured in the holding sections 142 the fastening device 14 can be turned as described above until the desired contact is established and the interconnection device 1 is securely fastened to the solar module 2.

Figure 4b shows the activation of the closing bar 146 that has a rotated the catches 1450 by 45°. In this preferred embodiment, the catches 1450 are flat metal plates, which are inserted into slits 147 provided in the body 140 of the fastening device 14 and are held by the axles 148, which are sitting in openings of the fastening device 14. Hence, only the part 1455 of the catches 1450 that comprises the second opening 1452 needs to extend out of the slit 47 of the fastening device 14. The catches 1450 are therefore almost fully integrated into the fastening device 14 and do therefore not obstruct the process of winding the ribbons 21 around the fastening device 14.

Figure 4c shows the closed catches 1450 that hold the ribbons 21 within the holding sections 142 of the connecting elements 141. Below each ribbon 21 is an electrical conductor 12 attached to the lever of the related catch 1450. The ribbons 21 and the related electrical conductors 12 are therefore layered upon each another when the fastening device 14 is turned, so that contact is established and maintained over a wide contact area.

Figure 5 shows an inventive interconnection device 1 during the installation procedures. The housing 10 is cut open providing a view to the elements of the interconnection device 1. After the installation, the interconnection device 1 is attached to the solar module 2 by means of the ribbons 21. In order to prevent accidental stress on the ribbons 21 the housing 10 may further be fastened to the solar module by means of screws 6 that are inserted into corresponding screw holes 1031. The screws 1031 are preferably selected in such a way that they cannot be operated with standard tools, thus providing a first barrier against tampering. In a preferred embodiment, the front-side of the screws is drilled into thread holes provided in a metallic plate, which is preferably laminated into the solar module. However in the event that an unauthorised person is able to remove the screws 6, then the housing 10 is still kept in place by means of the ribbons 21. Applying further force on the housing will then damage the solar module 2, leaving it useless for the present owner. Typically the force required to remove the housing 10 will create a damage that can not be fixed.

It is however shown, that the rightful user has a "key", namely a permanent magnet 8 or means, such as the above mentioned release code, for activating an electromagnet 8 that is capable to release the ratchet lever 18 and the fastening device 14. The release mechanism can be made in one of different suitable embodiments that are not disclosed to unauthorised persons who therefore have no means to access the interconnection device 1.

Figure 5 further shows that one of the side walls 102 comprises an opening 1021 through which the fastening device 14 and the closing bar 146 extend out of the housing.

As shown in Figure 5, if the fastening device 14 is lowered, e.g. to a pint where the bearing 16 is reaching the bottom 101, the catches 1450 reach out of the openings 1011 so that the ribbons 21 can be grasped outside the housing 10.

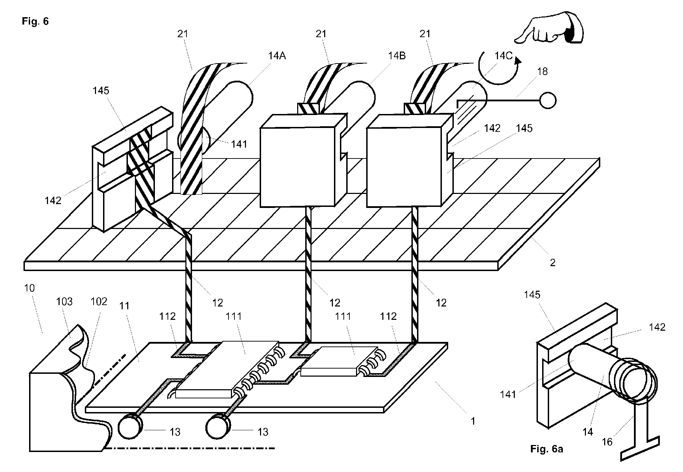

Figure 6 shows an inventive interconnection device 1 in a further principal embodiment. In this embodiment three rotatable fastening devices 14A, 14B, 14C are provided that are designed as screws, which are held in a bearing 16 that comprises a threaded hole (schematically shown in figure 6a). The bearing may be part of the housing or may be integrated within the housing 10. The tip of each fastening device 14A, 14B, 14C, serves as the connecting element 141 which is rotated towards the holding section 142 of a catch 145 that is formed as a recess in the catch 145. The individual catches 145 are preferably designed in a common element that is held within the housing 10 preferably attached to a wall, the bottom and/or the cover. In order to facilitate the coupling of the ribbons 21 with the electrical conductors 12 provided within the interconnection device 1, the electrical conductors 12 are connected to the catches 145 preferably attached to the surface and integrated into the recess. Hence, only the ribbons 21 need to be moved against the catch 145, while the electrical conductors 12 are already fixed. After the ribbons 21 have been pressed by means of the fastening device 14 against the catch 145, the ribbons 21 and the electrical conductors 12 form laminar layers providing an excellent electrical contact. The ratchet 18 described above will be applied for each of the fastening devices 14A, 14B and 14C. The release mechanism for the ratchets 18 may be applied in the same manner.

The electronic circuitry used in the above described embodiments, e.g. the control unit 11, can host by-pass diodes or the by-pass diodes can be attached directly to electrical connectors inside the housing 10.

## Claims

1. Interconnection device (1) with a housing (10) accommodating connecting elements (141) designed for interconnecting ribbons (21) of a solar module (2), which are electrically connected to photovoltaic cells, with electrical conductors (12) that are coupled directly or via a control unit (11) to electrical connectors (13) that are accessible on the housing (10), **characterised in that** each connecting element (141) is part of at least one rotatable fastening device (14; 14A, 14B, 14C), such as a mandrel, and with at least one catch (145, 1450) designed for holding a related ribbon (21) in a holding section (142) and wherein the at least one rotatable fastening device (14)
a) is rotatably held by at least one bearing (16),
b) is coupled to at least one ratchet (18, 181), which allows turning the fastening device (14) in one direction only, and
c) is accessible from the outside of the housing (10).

2. Interconnection device (1) according to claim 1, **characterised in that** each rotatable fastening device (14; 14A, 14B, 14C) is provided with a screw thread and held in a separate threaded hole and is rotatable with the connecting element (141) formed by the tip of the fastening device (14; 14A, 14B, 14C) towards the related catch (145, 1450) that comprises the holding section (142) preferably therein provided as a recess.

3. Interconnection device (1) according to claim 1, **characterised in that** each connecting element (141), comprises at least one of said catches (145, 1450) that are designed for grasping and holding a related ribbon (21) within a holding section (142) of the connecting element (141), that are mounted on individual fastening devices (14A, 14B, 14C) or on a common fastening devices (14) which are or is designed to wrap up the related ribbons (21).

4. Interconnection device (1) according to claim 3, **characterised in that**
a) the catch (145) is fixedly connected or part of the connecting element (141) acting as a fork for picking up and holding the ribbon (21) or
b) that the catch (1450) is pivotally mounted on the fastening device (14) or on the connecting element (141).

5. Interconnection device (1) according to claim 3 or 4, **characterised in that** the fastening device (14) is movable along its axis in order to actuate and/or engage the catch (145, 1450) with the related ribbon (21).

6. Interconnection device (1) according to claim 3, 4 or 5, **characterised in that** a closing bar (146), which is integrated into or attached to the fastening device (14) that interacts with each catch (1450) is held movable co-axially to the fastening device (14).

7. Interconnection device (1) according to one of the claims 1 to 6, **characterised in that** the fastening device (14) is extending out of an opening (1021) of the housing (10) or that the fastening device (14) is accessible through an opening (1021) of the housing (10) by means of a tool, such as a screw driver.

8. Interconnection device (1) according to one of the claims 1 to 7, **characterised in that** the fastening device (14) comprises a body with recesses (1401) that interact with the at least one ratchet (18, 181) or that a mechanical element such as a toothed wheel attached to the fastening device (14) is interacting with the ratchet (18) that is preferably releasable.

9. Interconnection device (1) according to one of the claims 1 to 8, **characterised in that** the ratchet (18, 181) comprises a slideably or pivotally held element (18) that interacts with the fastening device (14) and that is made of material that is reacting to a magnetic force allowing to release the ratchet (18, 181).

10. Interconnection device (1) according to one of the claims 3 to 9, **characterised in that** the electrical conductors (12) are wires or ribbons that together with the ribbons (21) of the solar module (2) can be wound around the fastening device (14) so that a contact is established between the electrical conductors (12) and the ribbons (21) of the solar module (2) either directly or via the metallic connecting elements (141) or catches (145, 1450).

11. Interconnection device (1) according to one of the claims 1 to 10, **characterised in that** the electrical conductors (12) are connected to a control unit (11), which is acting in such a way that the transfer of electrical energy from the photovoltaic cell via the interconnection device (1) is interrupted in the event that a verification procedure, such as the comparison of an entered password with a password stored in the control module (10), which is changed after detection of tampering or theft, has provided a negative result.

12. Interconnection device (1) according to one of the claims 1 to 11, **characterised in that** the housing (10) is tamper-proof and thus not providing access to the interior.

13. Interconnection device (1) according to one of the claims 1 to 12, **characterised in that** the housing (10) is fastened to the solar module (2) by means of the ribbons (21) wound around and held by the fastening device (14) and/or that the housing (10) is fastened to the solar module (2) by means of an adhesive or mechanical connecting elements.

14. Solar module (2) provided with the interconnection device (1) according to one of the claims 1 to 13.
